# EUROPEAN PATENT APPLICATION

(11) **EP 2 549 550 A1**
(43) Date of publication of application: **23.01.2013**
(21) Application number: 11756328.8
(22) Date of filing: 09.03.2011
(51) Int. Cl.: H01L 31/042, F16J 15/10

(54) **PACKING FOR LAMINATOR**

(30) Priority: 16.03.2010 JP 2010059400
(71) Applicant: Nisshinbo Holdings, Inc., Chuo-ku Tokyo 103-8650 (JP)
(72) Inventor: NAKAHAMA Hidenari, Aichi 4448560 (JP); MAEDA Shuji, Aichi 4448560 (JP); NAKANO Hiroshi, Aichi 4448560 (JP)
(74) Representative: Leifert & Steffan
(86) International application number: PCT/JP2011/056143
(87) International publication number: WO 2011/115144

(57) **Abstract**

Disclosed is a novel packing for a solar cell module laminator. An object is to solve the problem of durability involved in conventional packings and to stably manufacture a high-quality module over a long period of time. The packing is composed of an olefin based rubber crosslinked with an organic peroxide and allowed to have a Shore A hardness, a dimensional stability, and a compression set each falling within a certain range. The olefin based rubber is suitably an EPDM rubber and/or an EPM rubber and is made possible for achieving extrusion molding.

## Description

### TECHNICAL FIELD

The present invention is an invention related to a packing for a solar cell module laminator.

### BACKGROUND ART

In general, a solar cell module has a structure in which a solar cell element and an encapsulant are sealed between a glass sheet and a back sheet. For a manufacture of a module, a laminator of a double vacuum system as disclosed in, for example, Patent Document 1 is widely used. An outline of laminating steps includes (1) disposing a member constituting a module (laminate of a glass, a solar cell element, an encapsulant, a back sheet, and the like) within a laminator apparatus, (2) evacuating the inside of the laminator apparatus, (3) pressing a diaphragm sheet against the member, and (4) heating to fuse and crosslink the encapsulant. The evacuating step (2) is an important step for the purpose of preventing deterioration or short life of the module to be caused due to the presence of air bubbles within the completed module.

In order to secure a degree of vacuum within the vacuum laminator apparatus, a packing is used on an engaging face between an upper case and a lower case of the laminator. Since rubber elasticity and heat resistance are required for the purpose of ensuring sealing properties, a silicone rubber has hitherto been used as a packing material.

[Patent Document 1] Japanese Utility Model Registration No. 3017231

### SUMMARY OF THE INVENTION

### PROBLEMS TO BE SOLVED BY THE INVENTION

However, at the time when the encapsulant of the module is fused and crosslinked in the step (4) of the foregoing laminating steps, a shortage in durability of the silicone rubber against a gas emitted and leaked from the encapsulant is a problem. For the encapsulant, an ethylene vinyl acetate resin (EVA) is used; however, a crosslinking component such as an organic peroxide, etc. or a silane coupling agent contained in EVA leaks out as a gas during the laminating processing, whereby the silicone rubber is eroded. The eroded silicone rubber packing causes swelling or hardening, so that its sealing properties are impaired. For that reason, it becomes difficult to secure the degree of vacuum of the laminator. In addition, though a packing made of a butyl rubber can be used, in the case of repeatedly conducting the laminating processing, the durability, in particular the fluctuation of a strain value is problematic.

In view of the foregoing problems, an object of the present invention is to provide a packing for a laminator with improved durability, thereby contributing to stable manufacture of a high-quality solar cell module.

### MEANS FOR SOLVING THE PROBLEMS

In order to achieve the foregoing object, the present inventors have found that by using an ethylene-propylene-diene rubber (EPDM rubber) crosslinked with a prescribed concentration of an organic peroxide and having specified hardness and viscosity, regulating a deformation ratio against the thermal change to a prescribed value, and further regulating a compression set to a prescribed value, favorable performances as a packing for a solar cell module laminator are revealed, and the durability is tremendously improved, leading to accomplishment of the present invention.

Specifically, the present invention provides:
(1) A packing for a solar cell module laminator comprising an olefin based rubber crosslinked with an organic peroxide and having a Shore A hardness of from 40 to 90, an addition amount of the organic peroxide being from 0.001 to 0.05 moles with respect to 100 parts by weight of the rubber component;
(2) The packing as set forth in (1), wherein the olefin based rubber crosslinked with an organic peroxide is (A) an ethylene-propylene-diene rubber (EPDM) and/or (B) an ethylene-propylene rubber (EPM);
(3) The packing as set forth in (1) to (2), wherein when a full length of the packing at 25 °C is defined as L₂₅, a full length of the packing at 100 °C is defined as L₁₀₀, and a full length of the packing at 150 °C is defined as L₁₅₀, a relation of (L₁₅₀ - L₂₅) / (L₁₀₀ - L₂₅) ≤ 1.4 is satisfied;
(4) The packing as set forth in (1) to (3), wherein when a diameter of the packing after subjecting the packing having an initial diameter Do to continuous repetition of compression at 150 °C for 33 minutes by the laminator and release for one minute during 40 days is defined as D₄₀, a relation of {(D₀ - D₄₀) /D₀} x 100 ≤ 20 (%) is satisfied;
(5) The packing as set forth in (1) to (4), wherein from 0.1 to 10.0 parts by weight of a silicone oil is blended into 100 parts by weight of the olefin based rubber crosslinked with an organic peroxide;
(6) The packing as set forth in (5), wherein the content of a cyclic dimethylsiloxane represented by the chemical formula (1) is not more than 500 ppm in the silicone oil,
[Chemical Formula 1] 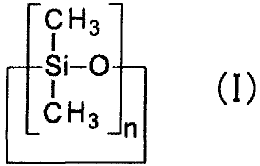 wherein n is from 3 to 10 in the chemical formula (1); and (7) A method for producing the packing as set forth in (1) to (6), comprising extrusion molding an olefin based rubber compound containing a crosslinking agent blended therein, and then crosslinking it.

As described above, the packing of a solar cell module laminator is required to have rubber elasticity and heat resistance for the purpose of securing the sealing properties. In addition, it is required to have durability against a volatilized gas from EVA. According to the present invention, it has been found that by using an olefin based rubber crosslinked with an organic peroxide and regulating a Shore A hardness to from 40 to 90, these performances required as a packing are obtainable. What the Shore A hardness is less than 40 is problematic because the material is too soft so that the sealing properties cannot be kept, whereas what the Shore A hardness exceeds 90 is also problematic because the material is too rigid so that the packing is hardly compressed, whereby the vacuum cannot be kept.

As the olefin based rubber, a copolymer of an olefin having a carbon number of from 3 to 8 and ethylene is used, and in particular, an ethylene-propylene-diene rubber (EPDM) and/or (B) an ethylene-propylene rubber (EPM) is suitable. These are preferable from the standpoint of durability against a gas emitted from EVA.

The present invention has a characteristic feature of using an organic peroxide as the crosslinking agent. The use of an organic peroxide is preferable from the standpoints that in comparison with the use of other crosslinking agents, long-term heat-resistant stability is excellent, and contamination on other materials to be caused due to bleeding of the crosslinking agent does not occur.

As the organic peroxide, dicumyl peroxide, di-t-butyl peroxide, t-butyl cumyl peroxide, 2,5-dimethyl-2,5-di(t-butylperoxy)hexane, 2,5-dimethyl-2,5-di(t-butylperoxy)hexine-3, 1, 1-bis-t-butylperoxy-3, 3, 5-trimethylcyclohexane, and the like can be used. Of these, bifunctional organic peroxides such as 2,5-dimethyl-2,5-di-(t-butylperoxy)hexane, 2,5-dimethyl-2,5-di-(t-butylperoxy)hexine-3, 1,3-bis(t-butylperoxyisopropyl)benzene, etc. are especially preferable from the standpoints of reactivity, odor property , and scorch stability. Above all, 2,5-dimethyl-2,5-di-(t-butylperoxy)hexane is the most preferable. In addition, as a crosslinking aid, triallyl isocyanurate, triallyl cyanurate, p,p-dibenzoyl quinone dioxime, p-quinone dioxime, 1,2-polybutadiene, trimethylolpropane trimethacrylate, and ethylene dimethacrylate can be preferably used.

In addition, an addition amount of the organic peroxide is from 0.001 to 0.05 moles with respect to 100 parts by mass of the rubber component. In the case where the addition amount is smaller than 0.001 moles, a deformation ratio against the thermal change is large, whereas in the case where the addition amount is more than 0.05 moles, the elasticity is impaired so that the function as a sealing material is not achieved.

In the case of using the organic peroxide crosslinking agent of the present invention, a crosslinking aid can also be used in combination. As the crosslinking aid, triallyl isocyanurate, triallyl cyanurate, p,p-dibenzoyl quinone dioxime, p-quinone dioxime, 1,2-polybutadiene, trimethylolpropane trimethacrylate, and ethylene dimethacrylate are preferably used.

For the purpose of improving the heat resistance, it is suitable that a heat-resistant stabilizer is contained in the olefin based rubber crosslinked with an organic peroxide. Unless a prescribed amount of the heat-resistant stabilizer is present within a depth of 2 mm from at least one side, there may be caused a problem from the standpoint of durability against a gas emitted from EVA. When the amount of the stabilizer is less than 0.1 wt%, sufficient effects cannot be exhibited. When it exceeds 5.0 wt%, there is a possibility that crosslinking at the time of extrusion molding of the rubber becomes insufficient.

For the purpose of trapping a radical of the organic peroxide in the gas emitted from EVA, it is suitable to use, as the heat-resistant stabilizer, a phenol based antioxidant or an arbitrary combination of a phenol based antioxidant with a phosphite based antioxidant, a thioether based antioxidant, or an amine based antioxidant. Above all, the case of an arbitrary combination of plural members is more effective.

A hindered phenol based antioxidant is preferably one having a molecular weight of 400 or more from the standpoint of heat resistance. In addition to the standpoint of heat resistance, when the molecular weight is less than 400, there may be the case where a phenomenon in which scattering or vaporization, or extraction into a substance with which the antioxidant comes into contact, occurs is observed. In consequence, one having a molecular weight of 400 or more is preferably used, and one having a molecular weight of 500 or more is more preferable. In addition, by selecting one having a high molecular weight, there also gives rise to an effect that the heat resistance of the composition can be enhanced.

Examples of such a hindered phenol based antioxidant having a molecular weight of 400 or more include 4,4'-methylene-bis-(2,6-di-t-butylphenol) (MW = 420), octadecyl-3-(3,5-di-t-butyl-4-hydroxyphenyl)propionate (MW = 531) (a trade name: IRGANOX 1076, available from Ciba Specialty Chemicals Inc.), pentaerythritol tetrakis[3-(3,5-di-t-butyl-4-hydroxyphenyl)propionate] (MW = 1,178) (a trade name: IRGANOX 1010, available from Ciba Specialty Chemicals Inc.), 3,9-bis[2-[3-(3-t-butyl-4-hydroxy-5-methylphenyl)propionyl oxy]-1,1-dimethylethyl]-2,4,8,10-tetraoxaspiro[5.5]undecan e (MW = 741) (a trade name: SUMILIZER GA-80, available from Sumitomo Chemical Co., Ltd.), and so on.

Examples of the phosphite based antioxidant include tris-(2,4-di-t-butylphenyl)phosphite (a trade name: IRGAFOS 168, available from Ciba Specialty Chemicals Inc.; a trade name: ADEKA STAB 2112, available from Adeka Corporation; etc.), bis-(2,4-di-t-butylphenyl)pentaerythritol-diphosphite (a trade name: IRGAFOS 126, available from Ciba Specialty Chemicals Inc.; a trade name: ADEKA STAB PEP-24G, available from Adeka Corporation; etc.), bis-(2,6-di-t-butyl-4-methylphenyl)pentaerythritol-diphosp hite (a trade name: ADEKA STAB PEP-36, available from Adeka Corporation), distearyl-pentaerythritol-diphosphite (a trade name: ADEKA STAB PEP-8, available from Adeka Corporation; a trade name: JPP-2000, available from Johoku Chemical Co., Ltd.; etc.), and so on. From the standpoint of an enhancement of hydrolysis resistance, those having a pentaerythritol structure are preferable, and those further having, in addition to the pentaerythritol structure, an aromatic hydrocarbon group containing a t-butyl group are especially preferable.

Examples of the thioether based antioxidant include 2,2-bis({[3-(dodecylthio)propionyl]oxy}methyl)-1,3-propane diyl=bis [3- (dodecylthio) propionate (a trade name: ADEKA STAB AO-412S, available from Adeka Corporation), ditridecan-1-yl=3,3'-sulfanediyl dipropanoate (a trade name: ADEKA STAB AO-503, available from Adeka Corporation), and so on.

As the amine based antioxidant, there can be exemplified aromatic amine based compounds such as diphenylamine, phenyl α-naphthylamine, etc. These can be used in combination with the foregoing hindered phenol based antioxidant or phosphite based antioxidant so far as the effects of the present invention are not inhibited.

The solar cell laminator is repeatedly subjected to the standby condition where preheating at about 100 °C is applied and to the heating condition at from about 150 °C to 180°C for conducting fusion and crosslinking of EVA. If a dimensional change corresponding to the temperature change as thus repeated is large, the sealing properties are lowered. For that reason, when a full length of the packing at 25 °C is defined as L₂₅, a full length of the packing at 100 °C is defined as L₁₀₀, and a full length of the packing at 150 °C is defined as L₁₅₀, it is suitable that a relation of (L₁₅₀ - L₂₅) / (L₁₀₀ - L₂₅) ≤ 1.4 is satisfied. When the thermal expansion of the packing is large such that the value exceeds 1.4, the packing set in the laminator becomes excessively long following an increase of the temperature in the laminator (an increase of from room temperature to the vicinity of 180 °C), and therefore, the packing is partially protruded from a set portion (concave), leading to a fault that the sealing properties become insufficient. Incidentally, this value is not theoretically less than 1.

In order to secure the sealing properties, it is necessary that the packing itself deforms to bring an upper case and a lower case of the laminator into intimate contact with each other, and also, it is necessary that a compression set against the above-described temperature change, in particular in the vicinity of the crosslinking temperature falls within a specified range. In the packing of the present invention, it is specified that a dimensional change after the continuous use at 150 °C for 40 days falls within 20 %. That is, when a diameter of the packing after subjecting the packing having an initial diameter Do to continuous repetition of compression at 150 °C for 33 minutes by the laminator and release for one minute during 40 days is defined as D₄₀, it is specified that (Do - D₄₀) is not more than 20 % relative to Do. When this value is more than 20 %, there is caused such a problem that the strain can not return within a short period of time due to the repeating action by the laminator, and the sealing properties become insufficient.

According to the packing of the present invention, the durability against the EVA gas is tremendously improved, and therefore, the frequency of exchange following the deterioration as in the conventional silicone rubbers is relatively significantly lowered. However, it is suitable to blend from 0.1 to 10.0 parts by weight of a silicone oil in the packing because it becomes easy to take out the packing from the upper case and/or the lower case at the time of exchange. When the amount of the silicone oil in the packing exceeds 10.0 parts by weight, the bleeding amount becomes large, and it attaches to other members or modules so as to impair the appearance, and it possibly results in deterioration of handling properties during the conveyance of the packing.

It is suitable that the content of the cyclic dimethylsiloxane represented by the formula (1) (n is from 3 to 10) is not more than 500 ppm in the silicone oil to be blended. This is because the low-molecular weight cyclic dimethylsiloxane, which may attach to an electric contact point, may be carbonized due to an electric spark or the like, and it is known that it can cause the generation of contact failure; and therefore, such is prevented by decreasing the content of the low-molecular weight cyclic dimethylsiloxane.

In order to facilitate the extrusion molding, it is preferable to make the rubber compound before crosslinking have a Mooney viscosity ML₁₊₄ (100°C) of from 20 to 90. When the Mooney viscosity is less than 20, there is caused such a problem that the dimensional stability is lost, whereas when it exceeds 90, there is a concern that a problem that the molding becomes difficult is caused.

A rubber compound in a continuous rope form is obtained by extrusion molding. By allowing the rubber compound in a continuous form to pass through a heating step as it is, a crosslinked rubber can be continuously obtained. A crosslinked rubber can also be formed by a so-called batch treatment by cutting the rubber compound in a certain length and putting it in a heating furnace. In all of these cases, a packing can be obtained by crosslinking the extrusion-molded rubber compound.

In addition, a packing in a ring form can also be obtained by connecting ends of packings in a rope form to each other with a rubber compound and subsequently crosslinking the thus connected portion. In general, though such a packing in a ring form is suitable as a packing for a laminator, it is also possible to mold the packing in an arbitrary shape depending upon a shape required from the structure of a joint portion between the upper case and the lower case of the laminator.

Conventionally, in the case of obtaining a packing in a ring form, execution of connecting ends of packings to each other with a liquid silicone which are crosslinkable at room temperature is frequently carried out on the spot. In that case, the sealing properties may be lowered due to bleeding of the adhesive in the joint part. For that reason, in order to secure the degree of vacuum, there was involved a problem from the economic standpoint that it should cope therewith by increasing the vacuum facilities or the like. However, according to the present invention, the packing can be molded in a ring form in advance, and therefore, the foregoing problem can be overcome.

### EFFECTS OF THE INVENTION

The packing for a laminator of the present invention establishes rubber elasticity for exhibiting close adhesion, heat resistance, durability against an EVA gas, a small dimensional change against thermal change, and the like at high levels. Accordingly, the packing for a laminator of the present invention results in stable manufacture of a high-quality solar cell module over a long period of time.

### BEST MODES FOR CARRYING OUT THE INVENTION

The present invention is specifically described with reference to Examples, but it should not be construed that the present invention is limited to these Examples.

### [Example 1]

5 parts by weight of zinc oxide, 1 part by weight of stearic acid, 80 parts by weight of carbon black, ASAHI #60G (manufactured by Asahi Carbon Co., Ltd.), and 50 parts by weight of a process oil (PW380, manufactured by Idemitsu Kosan Co., Ltd.) were blended into 100 parts by weight of an ethylene-propylene based rubber, EPT-4070 (manufactured by Mitsui Chemicals, Inc.), and the contents were kneaded for 6 minutes by a 16-L internal mixer. After the compound temperature was confirmed to reach 90 °C or less, LUPEROX 101XL (manufactured by ARKEMA Yoshitomi Co., Ltd.) was added as an organic peroxide in an amount of 0.01 moles (3.2 parts by weight) using a 14-inch roll. Furthermore, 0.1 parts by weight of pentaerythritol tetrakis[3-(3,5-di-t-butyl-4-hydroxyphenyl)propionate] (a trade name: IRGANOX 1010) that is a phenol based antioxidant and 0.1 parts by weight of a trade name, ANTAGE RD that is an amine based antioxidant were added as heat-resistant stabilizers, followed by sheeting of a rubber compound in a strip form. Thereafter, the compound was continuously discharged from a circular nozzle and crosslinked at 250 °C for 5 minutes in UHF and HAV continuous crosslinking tanks, thereby obtaining a crosslinked and extruded continuous packing having a columnar shape of φ10 mm. Incidentally, in the UHF vulcanization tank the temperature was set to 230 °C and the output was set to 2 kW, and the temperature in the HAV vulcanization tank was set to 250 °C.

The hardness of the packing was measured according to JIS K6253.

### [Examples 2 to 6 and Comparative Examples 3 to 6]

Packings were obtained in the same manner as that in Example 1, except that the kind and amount of each substance to be blended in the raw material rubber were changed as shown in Tables 1 and 2.

### [Comparative Example 1]

As a packing utilizing a butyl rubber, EXXON BROMOBUTYL 2244 was used as Comparative Example 1. The composition and hardness are shown in Table 2.

### [Comparative Example 2]

As a silicone rubber packing, a tubular product of φ10 mm of DOW CORNING TORAY SE 1186U was used as Comparative Example 2.
(1) Measurement of full length at every temperature:
   A packing was heated at 100 °C and 150 °C, respectively by a heater, and a full length in the respective case was measured. The measured full lengths were denoted as L₁₀₀ and L₁₅₀, respectively, and then (L₁₅₀ - L₂₅) / (L₁₀₀ - L₂₅) was calculated with L₂₅, a full length at 25 °C.
(2) Repeated laminating test:
   A tubular packing having a diameter of φ10 mm was set in a solar cell module laminator (LAM 1537, manufactured by Nisshinbo Mechatronics Inc.), the laminator was closed with a squeeze of 30 % (to start compression of the packing), and reducing the pressure at 150 °C for 3 minutes, compressing for 30 minutes, and releasing for one minute were continuously repeated for 40 days. The packing was measured for an initial diameter Do and a diameter D₄₀ after 40 days, respectively, and a rate of change in the diameter {(D₀ - D₄₀) / D₀} × 100 was calculated. This value becomes smaller, which means that the change in the diameter is smaller, and hence, it can be judged that the packing has stable dimensions over a long period of time. It is meant that when this value is large, the deterioration of the degree of vacuum occurs.
(3) Measurement of degree of vacuum:
   An unused packing was installed in a laminator, and then two minutes after start of the pressure reduction, a degree of vacuum (Pa) was measured. The operation was continued for 40 days without exchanging the packing, and a degree of vacuum (Pa) was similarly measured.
(4) After repeating the lamination for 40 days in (2), the separation state when the packing was separated from the installation portion was observed and evaluated according to the following criteria.
   3: Sticking is not observed at all.
   2: Sticking is partially observed.
   1: Sticking is observed to an extent of adherence.
   0: The oil bleeds to contaminate other members.

Results of the evaluation tests (1) to (4) regarding the Examples and Comparative Examples are shown in Tables 1 and 2.

In the butyl rubber of Comparative Example 1, it is noted that since the rate of change in the diameter {(D₀ - D₄₀) / D₀} × 100 is large, the durability against the continuous use is insufficient, and the life of the packing is short. In addition, in Comparative Example 2 (silicone rubber), the value of (L₁₅₀ - L₂₅) / (L₁₀₀ - L₂₅) is large, so the dimensional stability is insufficient.

In Examples 1 to 6, it is noted that by regulating the hardness of the packing to from 40 to 90, the shape change in the packing is small and the life becomes long. It is noted that when the hardness falls outside the specified range, the strain is large so that the exchange cycle becomes short as seen in Comparative Examples 3 to 4, even in the same olefin based rubber raw material.

It is noted from the results of Example 4 and Comparative Example 5 that when the amount of the crosslinking agent is not proper, the value of (L₁₅₀ - L₂₅) / (L₁₀₀ - L₂₅) is large, namely, the thermal expansion against the temperature change is large so that the degree of vacuum cannot be kept.

It is noted from the results of Examples 1 to 6 and Comparative Example 5 that in the case where the amount of the crosslinking agent is too large, when a silicone is not present at all, the separation from the hole part at which the packing is set becomes difficult, and the workability is poor. In addition, from the results of Comparative Example 6, in the case where the amount of the crosslinking agent is small, the packing cannot be separated so far as the silicone is not added, but the bleeding of the oil became large to contaminate other members, resulting in a problem.

**Table 1**

| | Example 1 | Example 2 | Example 3 | Example 4 | Example 5 | Example 6 |
|---|---|---|---|---|---|---|
| Raw material olefin based rubber | EPT4070 | EPT4070 | EPT4070 | EPT4070 | EPT4070 | EPT4070 |
| Kind of rubber | EPDM | EPDM | EPDM | EPDM | EPDM | EPDM |
| Parts by weight of rubber | 100 | 100 | 100 | 100 | 100 | 100 |
| Carbon black (parts by weight) | 80 | 70 | 110 | 60 | 80 | 80 |
| Process oil (parts by weight) | 50 | 60 | 40 | 70 | 50 | 50 |
| Zinc white (parts by weight) | 5 | 5 | 5 | 5 | 5 | 5 |
| Stearic acid (parts by weight) | 1 | 1 | 1 | 1 | 1 | 1 |
| Antioxidant: Phenol based material (parts by weight) | 0.1 | 0.1 | 0.1 | 0.1 | 0.1 | 0.1 |
| Antioxidant: Amine based material (parts by weight) | 0.1 | 0.1 | 0.1 | 0.1 | 0.1 | 0.1 |
| Silicone oil (parts by weight) | 0 | 0 | 0 | 0 | 5 | 0.1 |
| Organic peroxide (moles) | 0.01 | 0.007 | 0.012 | 0.01 | 0.01 | 0.01 |
| Shore A hardness | 60 | 50 | 80 | 40 | 60 | 60 |
| (L₁₅₀ - L₂₅)/(L₁₀₀ - L₂₅) | 1.2 | 1.2 | 1.2 | 1.3 | 1.2 | 1.2 |
| Initial degree of vacuum (Pa) | 50 | 52 | 54 | 50 | 52 | 51 |
| Degree of vacuum after 40 days (Pa) | 55 | 58 | 60 | 60 | 58 | 57 |
| {(D₀ - D₄₀)/D₀} × 100 | 12 | 10 | 15 | 15 | 11 | 12 |
| Sticking evaluation | 2 | 2 | 2 | 2 | 3 | 3 |

**Table 2**

| | Comparative Example 1 | Comparative Example 2 | Comparative Example 3 | Comparative Example 4 | Comparative Example 5 | Comparative Example 6 |
|---|---|---|---|---|---|---|
| Raw material rubber | EXXON BROMOBUTYL 2244 | DOW CORNING TORAY SE 1186U | EPT4070 | EPT4070 | EPT4070 | EPT4010 |
| Kind of rubber | Butyl rubber | Silicone rubber | EPDM | EPDM | EPDM | EPDM |
| Parts by weight of rubber | 100 | - | 100 | 100 | 100 | 100 |
| Carbon black (parts by weight) | 45 | - | 60 | 110 | 90 | 70 |
| Process oil (parts by weight) | 5 (Note 1) | - | 80 | 20 | 60 | 60 |
| Metal oxide: Zinc white (parts by weight) | - | - | 5 | 5 | 5 | 5 |
| Metal oxide: MgO (parts by weight) | 1 | - | - | - | - | - |
| Stearic acid (parts by weight) | 1 | - | 1 | 1 | 1 | 1 |
| Antioxidant: Phenol based material (parts by weight) | - | - | - | - | 0.1 | 0.1 |
| Antioxidant: Amine based material (parts by weight) | - | - | - | - | 0.1 | 0.1 |
| Silicone oil (parts by weight) | - | - | - | - | - | 15 |
| Organic peroxide (moles) | 0.007 (Note 2) | - | 0.01 | 0.01 | 0.06 | 0.0007 |
| Shore A hardness | 57 | 62 | 35 | 92 | 60 | 50 |
| (L₁₅₀ - L₂₅)/(L₁₀₀ - L₂₅) | 1.7 | 1.5 | 1.2 | 1.2 | 1.2 | 1.6 |
| Initial degree of vacuum (Pa) | 150 | 70 | 61 | 65 | 51 | 140 |
| Degree of vacuum after 40 days (Pa) | 170 | 200 | 160 | 150 | 54 | 160 |
| {(D₀ - D₄₀)/D₀} × 100 | 22 | 30 | 28 | 29 | 11 | 30 |
| Sticking evaluation | 1 | 2 | 2 | 2 | 1 | 0 |

| | | | | | | |
|---|---|---|---|---|---|---|
| Note 1: Flexon 580 oil Note 2: HVA-2 (DuPont) | | | | | | |

## Claims

1. A packing for a solar cell module laminator comprising an olefin based rubber crosslinked with an organic peroxide and having a Shore A hardness of from 40 to 90, an addition amount of the organic peroxide being from 0.001 to 0.05 moles with respect to 100 parts by weight of the rubber component.

2. The packing according to claim 1, wherein the olefin based rubber crosslinked with an organic peroxide is (A) an ethylene-propylene-diene rubber (EPDM) and/or (B) an ethylene-propylene rubber (EPM).

3. The packing according to claims 1 to 2, wherein when a full length of the packing at 25 °C is defined as L₂₅, a full length of the packing at 100 °C is defined as L₁₀₀, and a full length of the packing at 150 °C is defined as L₁₅₀, a relation of (L₁₅₀ - L₂₅)/(L₁₀₀ - L₂₅) ≤ 1.4 is satisfied.

4. The packing according to claims 1 to 3, wherein when a diameter of the packing after subjecting the packing having an initial diameter Do to continuous repetition of compression at 150 °C for 33 minutes by the laminator and release for one minute during 40 days is defined as D₄₀, a relation of {(D₀ - D₄₀) /D₀} × 100 ≤ 20 (%) is satisfied.

5. The packing according to claims 1 to 4, wherein from 0.1 to 10.0 parts by weight of a silicone oil is blended into 100 parts by weight of the olefin based rubber crosslinked with the organic peroxide.

6. The packing according to claim 5, wherein a content of a cyclic dimethylsiloxane represented by a chemical formula (1) is not more than 500 ppm in the silicone oil, wherein n is from 3 to 10 in the chemical formula (1).

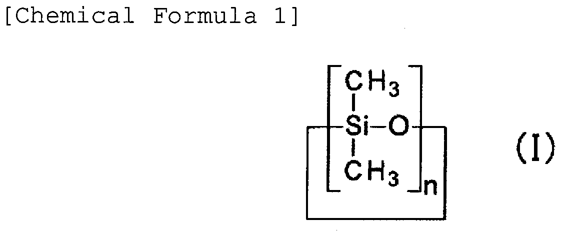

7. A method for producing the packing according to claims 1 to 6, comprising extrusion molding an olefin based rubber compound containing a crosslinking agent blended therein, and then crosslinking it.
